Europäisches Patentamt

European Patent Office

Office européen des brevets

(11) Publication number: **0 147 746**
**B1**

## EUROPEAN PATENT SPECIFICATION

(45) Date of publication of patent specification: **23.11.89**

(51) Int. Cl.⁴: **H 01 J 37/317**, G 11 B 5/845

(21) Application number: **84115442.0**

(22) Date of filing: **14.12.84**

(54) **Electron beam irradiation apparatus.**

(30) Priority: **16.12.83 JP 238510/83**

(43) Date of publication of application:
**10.07.85 Bulletin 85/28**

(45) Publication of the grant of the patent:
**23.11.89 Bulletin 89/47**

(84) Designated Contracting States:
**DE FR NL**

(56) References cited:
**EP-A-0 094 452**
**GB-A-1 416 200**
**JP-A-58 159 244**
**JP-A-58 203 633**
**JP-A-58 215 732**
**US-A-3 676 673**
**US-A-4 407 853**

**PATENTS ABSTRACTS OF JAPAN, vol. 7, no.
266 (P-239)1411r, 26th November 1983; &
JP-A-58 146 033**

**PATENTS ABSTRACTS OF JAPAN, VOL. 7, NO.
245 (P-233)1390r, 29TH OCTOBER 1983; &
JP-A-58 130 431**

The file contains technical information
submitted after the application was filed and
not included in this specification

(73) Proprietor: **Nissin-High Voltage Co., Ltd.**
**47, Umezu Takase-cho Ukyo-ku**
**Kyoto-shi Kyoto (JP)**

(72) Inventor: **Yamawaki, Masakatsu**
**8-50, Tateishi-cho**
**Ikeda-shi Osaka (JP)**
Inventor: **Sakamoto, Isamu**
**145, Katsura Minamitatsumi-cho**
**Nishikyo-ku Kyoto-shi, Kyoto (JP)**
Inventor: **Mizusawa, Kenichi**
**4-202, Suehiro-cho**
**Ibaraki-shi Osaka (JP)**
Inventor: **Iwamoto, Eiji**
**14-222, Uzumasa Tayabu-cho**
**Ukyo-ku Kyoto-shi Kyoto (JP)**

(74) Representative: **Kraus, Walter, Dr. et al**
**Patentanwälte Kraus, Weisert & Partner**
**Thomas-Wimmer-Ring 15**
**D-8000 München 22 (DE)**

(56) References cited:
**PATENTS ABSTRACTS OF JAPAN, VOL. 6, NO.
133 (P-129)1011r, 20TH JULY 1982; & JP-A-57
58 212**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to an electron beam irradiation apparatus for simultanously (a) irradiating a target comprising a substrate and magnetic particles with an electron beam and (b) orienting the axis of easy magnetization of the magnetic particles in a direction perpendicular to the substrate, said apparatus comprising an electron beam source which is capable of generating an electron beam and irradiating it in one direction, at least a first magnet member, at least a second magnet member which is disposed opposite the first magnet member across a gap which allows the target to pass therethrough and which second magnet member has a polarity different from that of the first magnet member, said first and second magnet members coacting to produce a magnetic field in the gap, a target supporting/shifting means which allows the target to pass through said gap perpendicular to the flux of the magnetic field.

The apparatus of the present invention is an irradiation system to be used for forming a vertically magnetized layer on a tape, web, disk or sheet, etc.

In one existing manufacturing method of magnetic tape, etc. a magnetic paste obtained by dispersing magnetic particles into a solution with an adequate additive is applied on a substrate such as plastic film, etc. as a magnetic layer, such substrate is caused to pass through repulsive magnetic field formed by opposingly disposing the magnets of the same polarity before such coated magnetic layer is ·hardened, the axis of easy magnetization of magnetic particles is set in parallel to the moving direction of film used as the base material by the magnetic field orientation process. Thereafter, such paste is hardened by heat or electron beam irradiation. A magnetic film thus obtained is so-called a horizontal magnetic film. However, a limitation of magnetic recording density of such horizontal magnetic film is no longer insufficient as a medium of high density recording which is required with recent fantastic progress in electronics technology.

Therefore, the vertical magnetic film is attracting attention as a medium which realizes high density recording. Namely, in a vertical magnetic film, the axis of easy magnetization of magnetic particles is oriented vertically to the surface of base material and thereby, recording density can be enhanced drastically.

As methods of manufacturing a vertically magnetized film, there are the method disclosed in JP—A—59—68826 (published on 18th April, 1984) and a so-called sputtering method using a magnetron sputter system. However, in the method of JP—A—59—68826, the film is hardened after vertical orientation of magnetic particles and therefore orientation sometimes becomes irregular. Also, the sputtering method is essentially a batch processing and is not suited to continuous manufacture. In addition, the vertical magnetic film obtained by the sputter method can not be said to have sufficient performance from the point of view of surface smoothness, etc.

According to another method for preparing a magnetic medium disclosed in US—A—4,548,833 and in PATENTS ABSTRACTS OF JAPAN, Vol. 7, No. 245 (P-233) [1390], October 29, 1983, as well as in JP—A—58—130 431 it is known to give magnetic particles in a paste layer on a substrate a certain orientation, for instance, 90° with the substrate, by means of a magnetic field, and to harden the paste during or immediately after the orientation by means of electron beam radiation. However, the aforementioned documents do not disclose an apparatus for carrying out this method.

An electron beam irradiation apparatus for simultaneously irradiating a target comprising a substrate and magnetic particles with an electron beam and orienting the axis of easy magnetization of the magnetic particles in a direction perpendicular to the substrate, is known from PATENTS ABSTRACTS OF JAPAN, Vol. 7, No. 266 (P-239) [1411], November 26, 1983 and JP—A—58—146 033. This apparatus uses solenoids each having no core, i.e. are no magnetic members, in order to make the magnetic field for the orientation with one solenoid being arranged above the substrate and the other solenoid being arranged concentrically to the first mentioned solenoid below the substrate. The electron beam directed to the substrate is converged by the upper solenoid. However, since there is no core in both solenoids the concentration of the magnetic field is relatively weak.

Another apparatus of the type mentioned in the beginning for carrying out the above method is known from JP—A—58—215 732 and PATENTS ABSTRACTS OF JAPAN, Vol. 8, No. 68 (P-264) [1505], March 30, 1984. In this apparatus there are provided two magnets which are disposed opposite to one another across a gap which allows the target to pass therethrough and which magnets face another with opposite polarities. However, this apparatus is not able to harden the coated film during but only immediately after the orientation of the ferromagnetic powder because the two magnets and the electron beam source are arranged at a distance from one another in the direction of the movement of the substrate. This distance is increased by a magnetic shield which is disposed between the magnets for the orientation and the electron beam source in order to suppress the influence of the magnetic field to the electron beam.

Finally, US—A—3,676,673 describes an apparatus which permits treatment of products with ionizing radiation in a controlled atmosphere and comprises an inner chamber positioned within an outer chamber and the workpiece to be treated passing through the inner chamber. The outer chamber has a radiationpermeable window in one surface and the second chamber has means for the passage of radiation in juxtaposition with the window in the outer chamber. The apparatus may also contain means for carrying the product to be treated, as well as cooling means at the end of the radiation path. The radiation source can be an electron beam accelerator. However, this apparatus does not include any magnets for orienting ferromagnetic particles in a coating.

It is an object of the present invention to provide an electron beam irradiation apparatus for simply and continously manufacturing a high quality vertical magnetic film.

This object is achieved with an electron beam irradiation apparatus of the type mentioned in the beginning which is characterized by a through hole provided in said first magnet member or defined between two first magnet members arranged side by side in the moving direction of said target and opposed by two second magnet members; said through hole being disposed to allow the electron beam irradiated from said electron beam source to pass therethrough to the target; means for maintaining the electron beam path in said through hole under vacuum; and cooling means which cools at least said magnet member(s); said gap between said first and second magnet members being from 5 to 100 millimeters.

The electron beam irradiation apparatus of the present invention is capable of continuously forming a high quality vertical magnetic film because a magnetic layer is hardened by electron beam irradiation within a magnetic field where magnetic particles of unhardened magnetic layer are vertically oriented. Accordingly the apparatus of the present invention is very effective as an apparatus for manufacturing a vertically magnetized film or disk for the industrial use which is attracting attention as a high density magnetic recording medium.

Preferred embodiments of the invention are now described with reference to the drawings wherein

Fig. 1 is a side view including a partial cross section of an embodiment of the electron beam irradiation apparatus to which the present invention is applied;

Fig. 2 is a front view including a partial cross section of the apparatus shown in Fig. 1;

Fig. 3 is a plan view including a partial cross section of the apparatus shown in Fig. 1;

Fig. 4 is another embodiment of the invention;

Fig. 5 is a schematic diagram of magnetic field of the apparatus shown in Fig. 4, however in the case when only one first and second magnet member would be used to show the distortion of the magnetic field in this case;

Fig. 6 shows the characteristic of position vs. magnetic flux density at the center plane of gap between magnet members.

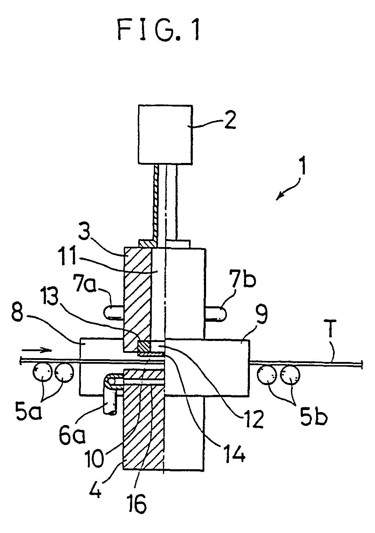

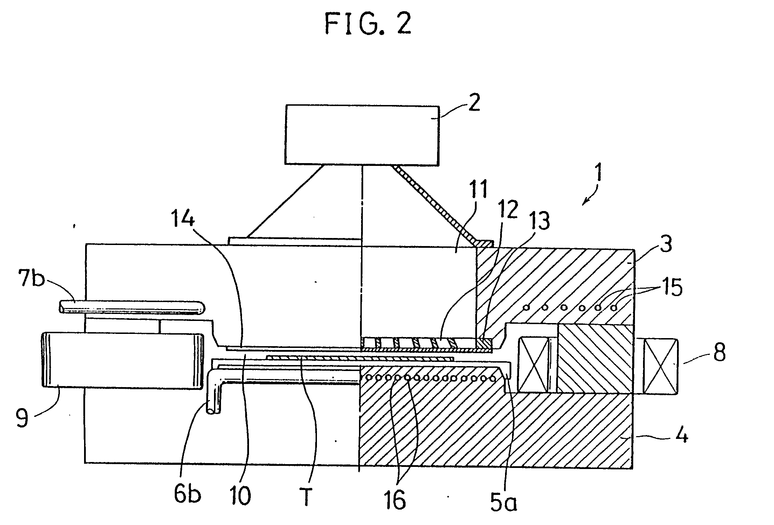

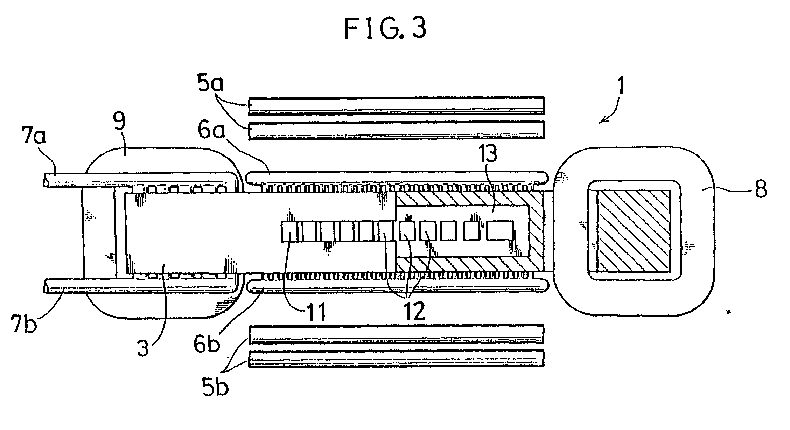

Fig. 1 to Fig. 3 show an embodiment of electron beam irradiation apparatus 1 of the present invention, comprising an electron beam source 2, a first magnet member 3, a second magnet member 4, film supporting/shifting means, i.e. rollers 5a and 5b and cooling means, i.e., coolant pipes 6a, 6b, 7a, 7b.

As an electron beam source 2, any of electron beam irradiation devices of the prior arts having an accelerator such as the Van de Graaff type, Cockcroft Walton type, transformer type or high frequency acceleration type may be used, without any particular limitation. However, it is preferable to use the device which assures irradiation of electron beam with an acceleration energy of 150 KeV to 1000 KeV and electron current of 10mA to 200mA or more. From the point of view of the shape of electron beam, the electron beam irradiation devices can be sorted into the two kinds. One is the scanning type where the belt shaped electron beam can substantially be obtained by scanning the elliptic beam spot of several millimeters and the other is nonscanning type where the belt shaped electron beam is directly obtained using the line shaped filament. Any kind of the apparatus may be employed.

The first magnet member 3 and the second magnet member 4 are electromagnets which excite the soft iron core with excitation coils 8, 9. Excitation coil may be installed around center pole piece being provided with means to avoid electron irradiation. In a gap 10 formed by opposing magnets, a magnetic field as high as 0.05 to 2 Tesla (500 to 20,000 Gauss), preferably 0.5 to 0.8 Tesla (5,000 to 8,000 Gauss), is formed. The magnet members 3, 4 may have the N-pole or S-pole, so long as these are different in the polarities. The magnet members 3, 4 may be permanent magnets.

The first magnet member 3 is provided with a bored through hole 11 which allows the electron beam to pass and a magnetic field shaping grill 13 having many apertures 12 is attached to the electron beam exit side of through hole 11. In case the electron beam is guided so that it can be transmitted through the through hole 11, disposition of the electron beam source 2 and the first magnet member 3 is not restricted but it is desirable from the point of view of constitution that the electron beam source 2 is disposed on the extended line of the through hole 11 of the first magnet member 3.

The grill 13 of through hole 11 is further provided with a metal foil 14. For example, the metal foil 14 is made of titanium or titanium alloy in a thickness of 10—50 μm or aluminum or aluminum alloy foil in a thickness of 10—100 μm. This metal foil vacuumly seals an electron flight space between the electron beam source 2 and the through hole 11. Outside of the metal foil 14, namely the area irradiated by electron beam is exposed to air; an inert gas such as nitrogen gas, rare gas or halogen gas. Moreover, the area to be irradiated with electron beam may be in vacuo. In case the area to be irradiated with electron beam is vacuumed, the metal foil 14 may be eliminated because it is no longer necessary to provide vacuum sealing.

An aperture area in the grill 13 is determined so that 20% or more, preferably 30—100% of the electron beam irradiated from the electron beam source 2 is transmitted to the area to be irradiated with electron beam. The shape of individual apertures 12 is selected to any shape of circle, rectangular, polygon or ellipse and it is desirable that individual aperture diameter is set smaller than the height of the gap 10 from the point of view of magnetic field shaping characteristic. As a practical example, when the height of gap 10 is 5—100 mm, the aperture is formed as a square having a side of 3—50 mm. A number of apertures 12 is uniquely determined from the aperture area but about 1—500 apertures are formed.

The tape supporting/shifting rollers 5a 5b supports and shifts a tape T while it is positioned at the symmetrical surface of magnetic field of the gap 10. The coolant pipes 6a 6b and 7a 7b cool the magnetic members 3 4 by allowing a refrigerant, for example, pure water, freon, etc. to flow into a cooling hole 15 provided to the first magnet member 3 and a cooling hole 16 provided to the second magnet member 4.

An example of manufacturing vertical magnetic film is explained hereinafter.

In manufacture of vertical magnetic film, a magnetic paste dispersing magnetic particles is applied on a base material such as plastic film, to form the magnetic layer.

Before hardening of such magnetic layer is completed, such magnetic particles are oriented for the vertical magnetic field by said electron beam irradiation apparatus 1. Simultaneously, such magnetic layer is hardened by electron beam irradiation.

As the magnetic particles, those which are suited to orientation for vertical magnetic field, for example, barium ferrite, $\gamma$—$Fe_2O_3$, $\gamma$—$Fe_2O_3$ coated with Co, and $CrO_2$, etc. may be used.

The magnetic paste may be prepared by using a solution which is mainly composed of an unsaturated resin and a monomer which are hardened by electron beam irradiation and contains a small amount of a dispersant.

As the unsaturated resins, unsaturated polyester, acrylic polyester and unsaturated epoxy resin, etc. may be used. As the monomers, acrylic acid ester, methacrylic acid ester, and vinyl hydrocarbon, etc. may be used.

As the base material mentioned above, a base material which can be used as the carrier of magnetic layer of magnetic recording body may be used without any restriction on material and shape. For example, a plastic film such as polyester, polyacetate, polyvinylchloride and polyimide, etc. or vinylchloride resin plate, polyester resin plate and polymethylmethacrylate resin plate, etc. which are used as magnetic disk may be used.

As a method of coating the base material with the magnetic paste dispersing magnetic particles, doctor blade method, reverse roll method, photogravure roll method and spinner method, etc. may be used. A coating apparatus which is usually used in this field may be freely employed. The layer is formed in the thickness of about 100 µm in maximum.

Here, a practical embodiment is mentioned. For example, the magnetic paste, where needle- shaped ferromagnetic ferric oxide (with long axis of 1 µm or less) is dispersed uniformly into a solution consisting of solvent mainly composed of unsaturated polyester resin and acrylic acid ester, a stabilizier, a dispersant, a antistatic agent, a lubricant and a coloring agent, is applied, by the doctor blade method, on a polyester tape in the width of 15 cm — 2 m which is precoated in the thickness of 5 µm — 30 µm, thereby, forming the magnetic layer film in the thickness of 1 µm — 10 µm. The tape T thus obtained is caused to run through the gap 10 by the tape supporting/shifting rollers 5a 5b while the film 2 is not yet hardened at the rate of 50 m/min—300 m/min, preferably at the rate of 100 m/min. Thereby, the magnetic field perpendicular to the magnetic layer film of tape T works to the tape and the axis of easy magnetization of magnetic particles is oriented vertically to the running direction of tape T. Simultaneously the film 2 is hardened by the electron beam irradiation, the vertical orientation is fixed and thereby the tape T forming suitably the vertical magnetization film can be manufactured continuously. The preferable amount of electron beam is 20 (kGy) — 100 (kGy).

The electron beam partly collides with the first magnet member 3, the grill 13 of it and the metal foil 14, or transmits through the tape T and collides with the second magnet member 4. Therefore, the magnet members 3, 4 generate heat and is then cooled by the refrigerant which flows through the coolant pipes 6a 6b, 7a 7b.

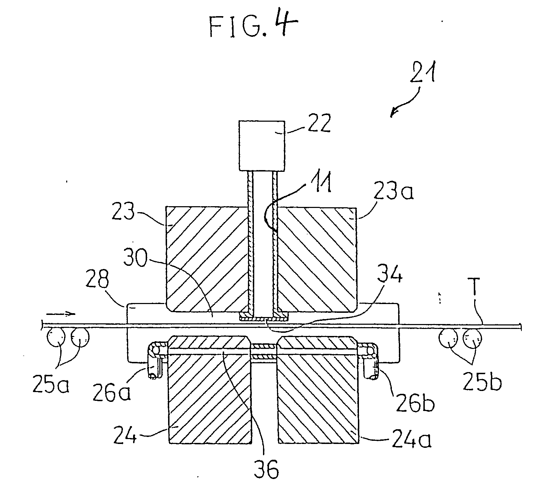

Fig. 4 shows another embodiment of the electron beam irradiation apparatus 21 to which the present invention is applied. This embodiment provides an electron beam source 22, one first magnet member 23, and one second magnet member 24 on the one side of the electron beam source 22, and another first magnet member 23a as well as another second magnet member 24a on the other side of the electron beam source 22, by which efficient hardening of magnetic layer may be achieved.

The electron beam source 22 is the same as the electron beam source 2 in the constitution itself but is different in the position for the magnet members. Namely, the electron beam source 22 is provided at the area near the single side of magnet members 23, 24. The internal space of the electron beam source 22 vacuumly sealed by metal foil 34 is highly vacuumed in such a degree of $1.33 \cdot 10^{-2}$ to $1.33 \cdot 10^{-5}$ Pascal ($10^{-4}$ to $10^{-7}$ Torr).

The first magnet member (23) and second magnet member 24 are basically the same as the first magnet member 3 and the second magnet member 4. However, the through hole such as the hole 11 of said first magnet member 3 is not provided to this first magnet.

It may be sometimes allowed that the cooling means is not particularly provided to the first magnet members 23, 23a because they generate less heat due to less collision of electron beam from their positional reason, but at least the second magnet member 24, 24a generate a considerable amount of heat due to the scattered electron beam. Accordingly, a cooling hole 36 is provided and the second magnet members 24, 24a can be cooled by a refrigerant which flows from the coolant pipes 26a, 26b.

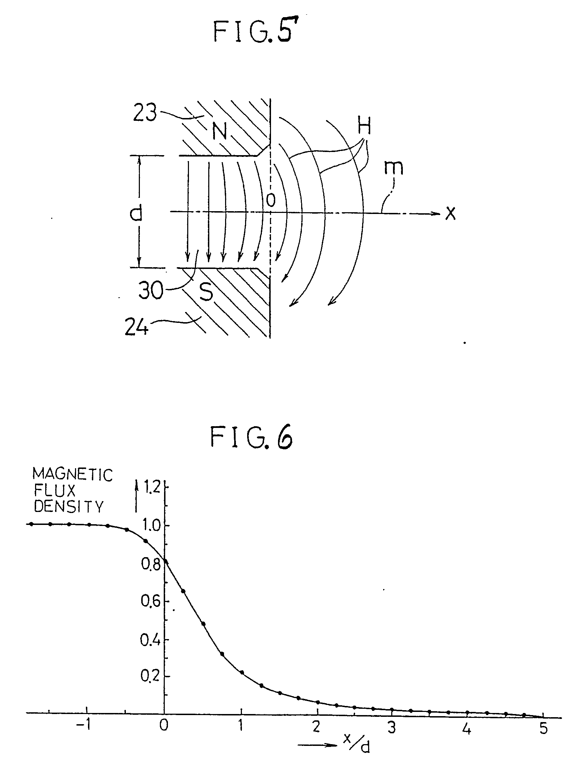

In case that only one first magnet member 23 would be used and set to N pole, while using only one second magnet member 24 set to S pole, the magnetic field H as shown in Fig. 5 would be formed. When both magnet members 23, 24 are disposed symmetrically to each other, the magnetic field H becomes perpendicular to the center plane m at the center plane m of gap 30. The magnetic flux density at the center plane m as shown in Fig. 6 can be obtained when the magnetic flux density at the center of gap 30 is 1.0, height of gap 30 is d, end surface position x of both magnet members 23, 24 is set to 0 (x = 0), and the direction toward the magnet members 23 24 is considered as the positive direction of x.

The film supporting/shifting rollers 25a 25b supportingly shifts the film T keeping the center plane m.

## Claims

1. An electron beam irradiation apparatus (1; 21) for simultaneously

(a) irradiating a target (T) comprising a substrate covered with a paste comprising magnetic particles with an electron beam and

(b) orienting the axis of easy magnetization of the magnetic particles in a direction perpendicular to the substrate;

said apparatus (1; 21) comprising an electron beam source (2; 22) which is capable of generating an electron beam and irradiating it in one direction, at least a first magnet member (3; 23, 23a), at least a second magnet member (4; 24, 24a) which is disposed opposite to the first magnet member (3; 23, 23a) across a gap (10; 30) which allows the target (T) to pass therethrough and which second magnet member (4; 24, 24a) has a polarity different from that of the first magnet member (3; 23, 23a), said first and second magnet members (3, 4; 23, 23a, 24, 24a) coacting to produce a magnetic field in the gap (10; 30), and a target supporting/shifting means (5a, 5b; 25a, 25b) which allows the target (T) to pass through said gap (10; 30) perpendicular to the flux of the magnetic field, characterized in that the magnet members are electro — or permanent magnet members and in that a through hole (11) is provided in said first magnet member (3) or defined between two first magnet members (23, 23a) arranged side by side in the moving direction of said target (T) and opposed by two second magnet members (24, 24a); said through hole (11) being disposed to allow the electron beam irradiated from said electron beam source (2, 22) to pass therethrough to the target (T);

means for maintaining the electron beam path in said through hole (11) under vacuum; and cooling means (6a, 6b, 7a, 7b; 26a, 26b) which cools at least said second magnet member(s) (4; 24, 24a);

said gap (10; 30) between said first and second magnet members (3, 4; 23, 23a, 24, 24a) being from 5 to 100 millimeters.

2. An electron beam irradiation apparatus according to claim 1, characterized in that said target supporting/shifting means (5a, 5b; 25a, 25b) supportingly shifts the target (T) within the center plane (m) of said gap (10; 30).

3. An electron beam irradiation apparatus according to claim 1 or 2, characterized in that said cooling means (6a, 6b, 7a, 7b) also cools said first magnet member (3).

4. An electron beam irradiation apparatus according to any one of claims 1 to 3, characterized in that the electron beam source (2; 22), the first magnet member (3) or members (23, 23a) and the second magnet member (4) or members (24, 24a) are linearly disposed in this sequence.

5. An electron beam irradiation apparatus according to claim 1, characterized in that the through hole (11) of the first magnet member (3) has the aperture area which allows 20% or more of electron beam irradiated from the electron beam source (2) to pass.

6. An electron beam irradiation apparatus according to claim 5, characterized in that the through hole (11) of the first magnet member (3) has an aperture area which allows 30 to 100% of the electron beam irradiated from the electron beam source (2) to pass.

7. An electron beam irradiation apparatus according to any one of claims 1 to 6, characterized in that the first and second magnet members (3, 4; 23, 24; 23, 23a, 24, 24a) have an intensity of magnetic poles which generates a magnetic field of 0.005 to 2 Tesla (50 to 20,000 Gauss) in the gap (10; 30) formed between said first and second magnet members (3, 4; 23, 23a, 24, 24a).

8. An electron beam irradiation apparatus according to any one of claims 1 to 7, characterized in that the first and/or second magnet members (3, 4; 23, 23a, 24, 24a) respectively have a bored refrigerant flowing hole (15, 16; 36).

9. An electron beam irradiation apparatus according to claim 8, characterized in that the cooling means (6a, 6b, 7a, 7b; 26a, 26b) causes a refrigerant to flow through the refrigerant flowing holes (15, 16; 36) bored to the first and/or second magnet members (3, 4; 24, 24a).

10. An electron beam irradiation apparatus according to any one of claims 1 to 9, characterized in that the target supporting/shifting means (5a, 5b; 25a, 25b) causes a film to which a magnetic paste dispersing particles is applied to run through the gap (10; 30) continuously between the magnet members (3, 4; 23, 23a, 24, 24a).

## Patentansprüche

1. Elektronenstrahl-Bestrahlungseinrichtung (1; 21) zum gleichzeitigen

(a) Bestrahlen eines Targets (T), das ein Substrat umfaßt, welches mit einer Paste bedeckt ist, die magnetische Teilchen umfaßt, mit einem Elektronenstrahl, und

(b) Ausrichten der Achse von leichter Magnetisierung der magnetischen Teilchen in einer Richtung senkrecht zu dem Substrat;

wobei die Einrichtung folgendes umfaßt: eine Elektronenstrahlquelle (2; 22), die in der Lage ist, einen Elektronenstrahl zu erzeugen und ihn in einer Richtung zu strahlen, wenigstens ein erstes Magnetteil (3; 23, 23a), wenigstens ein zweites Magnetteil (4; 24, 24a), das über einen Spalt (10; 30), welcher es ermöglicht, daß das Target (T) dadurch hindurchgeht, gegenüber dem ersten Magnetteil (3; 23, 23a) angeordnet ist, und welches zweite Magnetteil (4; 24, 24a) eine Polarität hat, die unterschiedlich von derjenigen des ersten Magnetteils (3; 23, 23a) ist, wobei das erste und zweite Magnetteil (3, 4; 23, 23a, 24, 24a) zum Erzeugen eines magnetischen Felds in dem Spalt (10; 30) zusammenwirken, und eine Targethalte-/-verschiebeeinrichtung (5a, 5b; 25a, 25b), welche es dem Target (T) ermöglicht, durch den Spalt (10; 30) senkrecht zu dem Fluß des magnetischen Felds hindurchzugehen, dadurch gekennzeichnet, daß die Magnetteile Elektro- oder Permanentmagnetteile sind und daß ein Durchgangsloch (11) in dem ersten Magnetteil (3) vorgesehen oder zwischen zwei ersten Magnetteilen (23, 23a), die nebeneinander in der Bewegungsrichtung des Targets (T) angeordnet sind und denen zwei zweite Magnetteile (24, 24a) gegenüberstehen, begrenzt ist; wobei das Durchgangsloch (11) so angeordnet ist, das es dem Elektronenstrahl, der von der Elektronenstrahlquelle (2, 22) gestrahlt wird; ermöglicht wird, durch dasselbe zu dem Target (T) hindurchzugehen; eine Einrichtung zum Halten des Elektronenstrahlwegs in dem Durchgangsloch (11) unter Vakuum; und eine Kühleinrichtung (6a, 6b, 7a, 7b; 26a, 26b), welche wenigstens das zweiten Magnetteil bzw. die zweiten Magnetteile (4; 24, 24a) kühlt; wobei der Spalt (10; 30) zwischen dem den ersten und zweiten magnetteilen (3, 4; 23, 23a, 24, 24a) von 5 bis 100 Millimeter beträgt.

2. Elektronenstrahl-Bestrahlungseinrichtung nach Anspruch 1, dadurch gekennzeichnet, daß die Targethalte-/-verschiebeeinrichtung (5a, 5b; 25a, 25b) das Target (T) innerhalb der Mittelebene (m) des Spalts (10; 30) haltend verschiebt.

3. Elektronenstrahl-Bestrahlungseinrichtung nach Anspruch 1 oder 2, dadurch gekennzeichnet, daß die Kühleinrichtung (6a, 6b, 7a, 7b) auch das erste Magnetteil (3) kühlt.

4. Elektronenstrahl-Bestrahlungseinrichtung nach irgendeinem der Ansprüche 1 bis 3, dadurch gekennzeichnet, daß die Elektronenstrahlquelle (2; 22), das erste Magnetteil (3) oder die ersten Magnetteile (23, 23a) und das zweite Magnetteil (4) oder die zweiten Magnetteile (24, 24a) linear in dieser Aufeinanderfolge angeordnet sind.

5. Elektronenstrahl-Bestrahlungseinrichtung nach Anspruch 1, dadurch gekennzeichnet, daß das Durchgangsloch (11) des ersten Magnetteils (3) den Öffnungs-Flächeninhalt hat, welcher es ermöglicht, daß 20% oder mehr des Elektronenstrahls, der von der Elektronenstrahlquelle (2) gestrahlt wird, hindurchgehen.

6. Elektronenstrahl-Bestrahlungseinrichtung nach Anspruch 5, dadurch gekennzeichnet, daß das Durchgangsloch (11) des ersten Magnetteils (3) einen Öffnungs-Flächeninhalt hat, welcher es ermöglicht, daß 30 bis 100% des Elektronenstrahls, der von der Elektronenstrahlquelle (2) gestrahlt wird, hindurchgehen.

7. Elektronenstrahl-Bestrahlungseinrichtung nach irgendeinem der Ansprüche 1 bis 6, dadurch gekennzeichnet, daß das erste und zweite Magnetteil bzw. die ersten und zweiten Magnetteile (3, 4; 23, 24; 23, 23a, 24, 24a) eine Intensität der Magnetpole haben, welche ein magnetisches Feld von 0,005 bis 2 Tesla (50 bis 20.000 Gauss) in dem Spalt (10, 30), der zwischen dem ersten und zweiten Magnetteil bzw. den ersten und zweiten Magnetteilen (3, 4; 23, 23a, 24, 24a) ausgebildet ist, erzeugt.

8. Elektronenstrahl-Bestrahlungseinrichtung nach irgendeinem der Ansprüche 1 bis 7, dadurch gekennzeichnet, daß das erste und/oder zweite Magnetteil bzw. die ersten und/oder zweiten Magnetteile (3, 4; 23, 23a, 24, 24a) jeweils ein gebohrtes Kühlmittelströmungsloch (15, 16; 36) hat bzw. haben.

9. Elektronenstrahl-Bestrahlungseinrichtung nach Anspruch 8, dadurch gekennzeichnet, daß die Kühleinrichtung (6a, 6b, 7a, 7b; 26a, 26b) bewirkt, daß ein Kühlmittel durch die Kühlmittelströmungslöcher (15, 16; 36), die in dem ersten und/oder zweiten Magnetteil bzw. in den ersten und/oder zweiten Magnetteilen (3, 4; 24, 24a) gebohrt sind, strömt.

10. Elektronenstrahl-Bestrahlungseinrichtung nach irgendeinem der Ansprüch 1 bis 9, dadurch gekennzeichnet, daß die Targethalte-/-verschiebeeinrichtung (5a, 5b; 25a, 25b) bewirkt, daß ein Film, auf den eine magnetische Paste, die Teilchen dispergiert, aufgebracht ist, kontinuierlich durch den Spalt (10; 30) zwischen den Magnetteilen (3, 4; 23, 23a, 24, 24a) läuft.

**Revendications**

1. Appareil d'irradiation par faisceau d'élec trons (1; 21) pour simultanément

(a) irradier une cible (T) comprenant un substrat recouvert d'une pâte contenant des particules magnétiques, avec un faisceau d'électrons, et

(b) orienter l'axe d'aimantation facile des particules magnétiques dans une direction perpendiculaire au substrat; ledit appareil (1; 21) comprenant une source de faisceau d'électrons (2; 22) qui est capable d'engendrer un faisceau d'électrons et de l'irradier dans une certaine direction, au moins un premier aimant (3; 23, 23a), au moins un deuxième aimant (4; 24, 24a) qui est disposé en face du premier aimant (3; 23, 23a) de l'autre côté d'un intervalle (10; 30) qui permet à la cible (T) de passer entre ces aimants, le deuxième aimant (4, 24, 24a) ayant une polarité différente de celle du premier aimant (3; 23, 23a), lesdits premiers et deuxièmes aimants (3, 4; 23, 23a, 24, 24a) coopérant pour produire un champ magnétique dans l'intervalle (10; 30), et des moyens de maintien/déplacement de cible (5a, 5b; 25a, 25b) qui permettent à la cible (T) de passer dans ledit intervalle (10; 30) perpendiculairement au flux du champ magnétique, caractérisé en ce que les aimants sont des électro-aimants ou des aimants permanents et en ce qu'un trou traversant (11) est prévu dans ledit premier aimant (3) ou défini entre deux premiers aimants (23, 23a) placés côte-à-côte dans la direction de déplacement de ladite cible (T) et en face de deux deuxièmes aimants (24, 24a); ledit trou traversant (11) étant disposé pour permettre au faisceau d'électrons émis par ladite source de faisceau d'électrons (2, 22) de passer dans ce trou vers la cible (T); des moyens pour maintenir le chemin du faisceau d'électrons dans ledit trou traversant (11) sous vide; et des moyens de refroidissement (6a, 6b, 7a, 7b; 26a, 26b) qui refroidissent au moins le ou les dits deuxièmes aimants (4; 24, 24a); ledit intervalle (10; 30) entre les dits premier et deuxième aimants (3, 4; 23, 23a; 24, 24a) étant de 5 à 100 mm.

2. Appareil d'irradiation par faisceau d'électrons, suivant la revendication 1, caractérisé en ce que lesdits moyens de maintien/déplacement de cible (5a, 5b; 25a, 25b) supportent et déplacent la cible (T) dans le plan central (m) dudit intervalle (10; 30).

3. Appareil d'irradiation par faisceau d'électrons suivant la revendication 1 ou 2, caractérisé en ce que lesdits moyens de refroidissement (6a, 6b, 7a, 7b) refroidissent également ledit premier aimant (3).

4. Appareil d'irradiation par faisceau d'électrons suivant l'une quelconque des revendications 1 à 3, caractérisé en ce que la source de faisceau d'électrons (2; 22), le premier aimant (3) ou les premiers aimants (23, 23a) et le deuxième aimant (4) ou les deuxièmes aimants (24, 24a) sont disposés linéairement, dans cette séquence.

5. Appareil d'irradiation par faisceau d'électrons suivant la revendication 1, caractérisé en ce que le trou traversant (11) du premier aimant (3) possède la section d'ouverture qui permet le passage de 20% ou plus du faisceau d'électrons irradié par la source de faisceau d'électrons (2).

6. Appareil d'irradiation par faisceau d'électrons suivant la revendication 5, caractérisé en ce que le trou traversant (11) du premier aimant (3) possède une section d'ouverture qui permet le passage de 30 à 100% du faisceau d'électrons irradié par la source de faisceau d'électrons (2).

7. Appareil d'irradiation par faisceau d'électrons suivant l'une quelconque des revendications 1 à 6, caractérisé en ce que les premiers et deuxièmes aimants (3, 4; 23, 24; 23, 23a, 24, 24a) ont une intensité de pôles magnétiques qui engendre un champ magnétique de 0,005 à 2 Tesla (50 à 20000 Gauss) dans l'intervalle (10; 30) défini entre les premiers et deuxièmes aimants (3, 4; 23, 23a, 24, 24a).

8. Appareil d'irradiation par faisceau d'électrons suivant les revendications 1 à 7, caractérisé en ce que les premiers et/ou deuxièmes aimants (3, 4; 23, 23a, 24, 24a) comportent respectivement un trou foré (15, 16; 36) pour la circulation de réfrigérant.

9. Appareil d'irradiation de faisceau d'électrons suivant la revendication 8, caractérisé en ce que les moyens de refroidissement (6a, 6b, 7a, 7b; 26a, 26b) provoquent la circulation d'un fluide réfrigérant dans les trous de circulation de réfrigérant (15, 16; 36) forés dans les premiers et/ou deuxièmes aimants (3, 4; 24, 24a).

10. Appareil d'irradiation par faisceau d'électrons suivant l'une quelconque des revendications 1 à 9, caractérisé en ce que les moyens de maintien/déplacement de cible (5a, 5b; 25a, 25b) ont pour effet qu'un film, auquel est appliquée une pâte magnétique avec des particules en dispersion, se déplace de façon continue dans l'intervalle (10; 30) entre les aimants (3, 4; 23, 23a, 24, 24a).

# FIG. 1

# FIG. 2

EP 0 147 746 B1

EP 0 147 746 B1

# FIG. 3

FIG. 4

# FIG. 5

# FIG. 6